# EUROPEAN PATENT APPLICATION

(11) **EP 4 578 329 A2**
(43) Date of publication of application: **02.07.2025**
(21) Application number: 24210709.2
(22) Date of filing: 05.11.2024
(51) Int. Cl.: A45C 11/00, A45F 5/00, G06F 1/00

(54) **ELECTRONIC DEVICE PROTECTIVE COVER**

(30) Priority: 25.12.2023 CN 202311798610
(71) Applicant: Getac Technology Corporation, New Taipei City 221009 (TW)
(72) Inventor: ZHONG, Shi-Liang, 11568 Taipei City (TW); CHIANG, Cheng-Hung, 11568 Taipei City (TW)
(74) Representative: Lucke, Andreas

(57) **Abstract**

An electronic device protective cover (100) is used to protect an electronic device (900). The electronic device protective cover (100) includes a first protective shell (110), a second protective shell (120), a pivot (130) and a rotatable hand strap module (200, 300). The pivot (130) is connected between the first protective shell (110) and the second protective shell (120), and the rotatable hand strap module (200, 300) is rotatably installed on the second protective shell (120).

## Description

### Technical Field

The present disclosure generally relates to a protective cover. More particularly, the present disclosure relates to an electronic device protective cover.

### Background

With the advancement of technology, the electronic products have become more popular, and gradually changed the life or work of many people. Besides good operation functions, the electronic products must also have portability as an important factor for users to consider purchasing.

The portable electronic devices are gradually developing toward the improvement of operating performance, and also gradually developing toward the direction of slim appearance. When the portable electronic device is being used or carried, the portable electronic device may be damaged if the portable electronic device is accidentally dropped.

In addition, when using a portable electronic device, a simple and smooth casing of the electronic device is not suitable for operation, and also inconvenient to watch movies or hand carry.

Hence, there is a need to provide an electronic device protective cover able to effectively protect an electronic device stored therein, easily carry the electronic device, and conveniently watch videos on the electronic device so as to improve the safety and convenience of the electronic device while using the electronic device.

### Summary

One objective of the embodiments of the present invention is to provide an electronic device protective cover to effectively protect an electronic device stored therein and further improve the safety and convenience while using the electronic devices.

To achieve these and other advantages and in accordance with the objective of the embodiments of the present invention, as the embodiment broadly describes herein, the embodiments of the present invention provides an electronic device protective cover to protect an electronic device. The electronic device protective cover includes a first protective shell, a second protective shell, a pivot and a rotatable hand strap module. The pivot is connected between the first protective shell and the second protective shell. The rotatable hand strap module is rotatably installed on the second protective shell.

In some embodiments, the first protective shell includes a first protective corner, a second protective corner and a connecting part. The connecting part is connected between the first protective corner and the second protective corner.

In some embodiments, the second protective shell includes a base plate, a third protective corner and a fourth protective corner. The third protective corner is disposed on the base plate and the fourth protective corner is disposed on the base plate. In addition, the first protective corner and the second protective corner are symmetrical to the third protective corner and the fourth protective corner.

In some embodiments, the second protective shell is rotatable a predetermined angle along the pivot.

In some embodiments, the rotatable hand strap module includes a rotating plate and a hand strap. The rotating plate is rotatably installed on the second protective shell. The hand strap penetrates through the rotating plate.

In some embodiments, the rotatable hand strap module further includes a fixed shaft penetrating through the rotating plate and the second protective shell so that the rotatable hand strap module is rotatably installed on the second protective shell.

In some embodiments, the fixed shaft includes an internal thread sleeve nut and an external thread bolt. The internal thread sleeve nut penetrates through the rotating plate and the second protective shell and the external thread bolt is fixed to the internal thread sleeve nut so that the rotatable hand strap module is rotatably installed on the second protective shell.

In some embodiments, the hand strap includes a first U-shaped part, a second U-shaped part connected to the first U-shaped part and a third U-shaped part connected to the second U-shaped part.

In some embodiments, the rotatable hand strap module further includes a fixing ring, and the first U-shaped part of the hand strap is fixed on the fixing ring.

In some embodiments, the second U-shaped part of the hand strap is fixed on the rotating plate.

In some embodiments, the third U-shaped part of the hand strap passes through the fixing ring to adjust a tightness of the hand strap.

In some embodiments, the rotatable hand strap module further includes a bonding device fixed on the third U-shaped part of the hand strap to adjust the tightness of the hand strap according to a requirement.

In some embodiments, the rotating plate of the rotatable hand strap module is connected to the hand strap, and the rotating plate and the hand strap are formed in one piece using double injection molding.

In some embodiments, the rotatable hand strap module further includes a fixing ring connected to the rotating plate. The fixing ring, the rotating plate and the hand strap are formed in one piece using double injection molding.

In some embodiments, the rotatable hand strap module further includes a bonding device formed on the hand strap to adjust a tightness of the hand strap according to a requirement.

According to another aspect of the present invention, an electronic device protective cover to protect an electronic device is provided. The electronic device protective cover includes a first protective shell, a second protective shell, a pivot and a rotatable hand strap module. The pivot is connected between the first protective shell and the second protective shell, and the first protective shell and the second protective shell surround the electronic device. In addition, the rotatable hand strap module is rotatably installed on the second protective shell.

In some embodiments, the first protective shell includes a first protective corner, a second protective corner and a connecting part. The connecting part is connected between the first protective corner and the second protective corner, and the first protective corner is fixed on a first corner of the electronic device and the second protective corner is fixed on a second corner of the electronic device.

In some embodiments, the second protective shell includes a base plate, a third protective corner and a fourth protective corner. The third protective corner is disposed on the base plate and the fourth protective corner is disposed on the base plate. In addition, the third protective corner is fixed on a third corner of the electronic device and the fourth protective corner is fixed on a fourth corner of the electronic device, and the first protective corner and the second protective corner are symmetrical to the third protective corner and the fourth protective corner.

In some embodiments, the electronic device protective cover further includes a plurality of fixing devices penetrating through the first protective corner, the second protective corner, the third protective corner and the fourth protective corner to fix the first protective corner on the first corner of the electronic device, the second protective corner on the second corner of the electronic device, the third protective corner on the third corner of the electronic device, and the fourth protective corner on the fourth corner of the electronic device.

In some embodiments, the second protective shell is able to rotate along the pivot to allow the electronic device to stand on a surface when some of the fixing devices are released to separate the third protective corner from the third corner of the electronic device and the fourth protective corner from the fourth corner of the electronic device.

Hence, the electronic device protective cover disclosed in the present invention may effectively protect the electronic device stored therein, and is convenient to carry and convenient for users to watch videos so as to be conveniently used in various environments and effectively improve the safety and convenience of the electronic device while using the electronic device.

### Brief Description of the Drawings

The foregoing aspects and many of the attendant advantages of this invention will be more readily appreciated as the same becomes better understood by reference to the following detailed description, when taken in conjunction with the accompanying drawings, wherein:
Fig. 1 illustrates a schematic perspective view showing an electronic device protective cover and an electronic device according to one embodiment of the present invention;
Fig. 2 is a schematic exploded view showing an electronic device protective cover and an electronic device according to one embodiment of the present invention; and
Fig. 3 is a schematic exploded view showing an electronic device protective cover and an electronic device according to another embodiment of the present invention.

### Detailed Description of the Preferred Embodiment

The following is a detailed description of the embodiments in conjunction with the accompanying drawings.

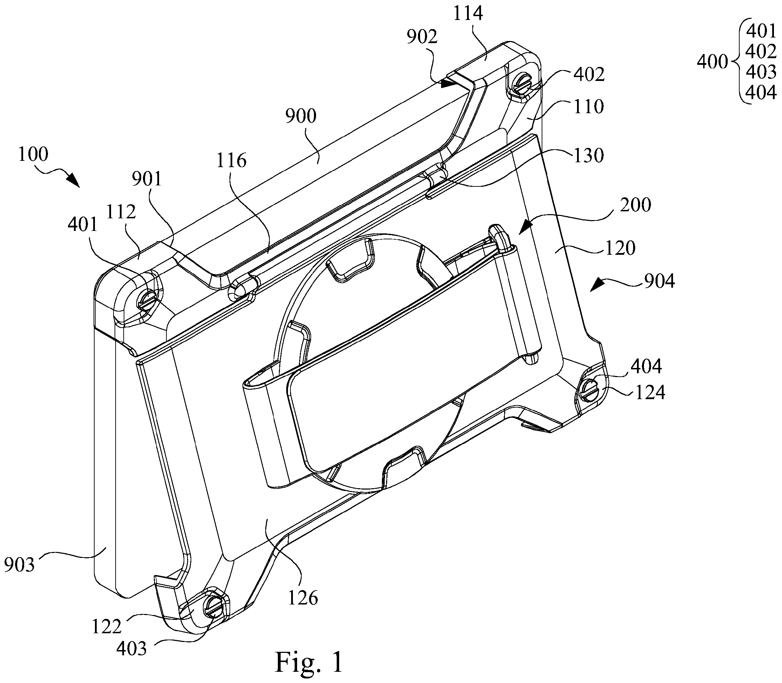

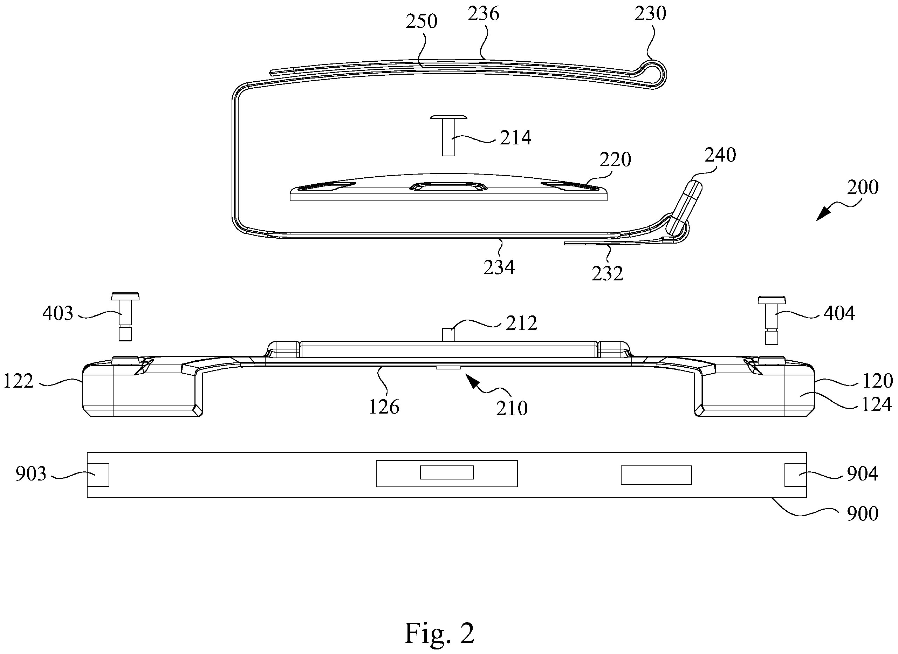

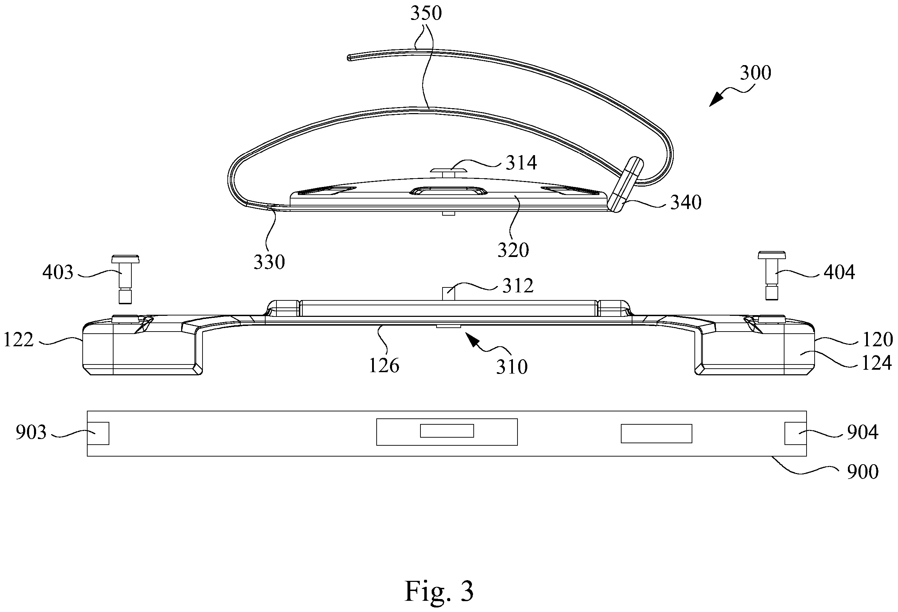

Fig. 1 illustrates a schematic perspective view showing an electronic device protective cover and an electronic device according to one embodiment of the present invention, and Fig. 2 is a schematic exploded view thereof. In addition, Fig. 3 is a schematic exploded view showing an electronic device protective cover and an electronic device according to another embodiment of the present invention.

Referring to Fig. 1 and Fig. 2, the electronic device protective cover 100 is utilized to protect an electronic device 900, such as a tablet computer, a mobile phone or any other electronic device.

The electronic device protective cover 100 includes a first protective shell 110, a second protective shell 120, a pivot 130 and a rotatable hand strap module 200. The pivot 130 is connected between the first protective shell 110 and the second protective shell 120 to allow the second protective shell 120 able to rotate relative to the first protective shell 110. The rotatable hand strap module 200 is rotatably installed on the second protective shell 120. Therefore, the rotatable hand strap module 200 may not only rotate relative to the second protective shell 120 but also rotate relative to the first protective shell 110.

In some embodiments, the first protective shell 110 and the second protective shell 120 of the electronic device protective cover 100 surround the electronic device 900 so as to effectively protect the electronic device 900.

Therefore, when a user holds the electronic device through the rotatable hand strap module 200, the electronic device fixed thereon may be rotated in at least two rotation directions relative to the hand of the user, and preferably the two rotation directions are perpendicular to each other, but not limited to this.

In some embodiments, the first protective shell 110 includes a first protective corner 112, a second protective corner 114 and a connecting part 116. The connecting part 116 is connected between the first protective corner 112 and the second protective corner 114. The first protective corner 112 is preferably fixed on the first corner 901 of the electronic device 900, and the second protective corner 114 is preferably fixed on the second corner 902 of the electronic device 900.

In some embodiments, the second protective shell 120 includes a base plate 126, a third protective corner 122 and a fourth protective corner 124. The third protective corner 122 and the fourth protective corner 124 are disposed on the base plate 126. In addition, the first protective corner 112 and the second protective corner 114 are preferably disposed symmetrically with the third protective corner 122 and the fourth protective corner 124.

In some embodiments, the third protective corner 122 is preferably fixed on the third corner 903 of the electronic device 900, and the fourth protective corner 124 is preferably fixed on the fourth corner 904 of the electronic device 900 to effectively utilize the first protective corner 112, the second protective corner 114, the third protective corner 122 and the fourth protective corner 124 to protect the first corner 901, the second corner 902, the third corner 903 and the fourth corner 904 of the electronic device 900. Therefore, the four corners of the electronic device 900 may be safely protected by the electronic device protective cover 100, thereby improving the impact resistance of the electronic device 900.

In addition, it is worth noting that the second protective shell 120 may rotate along the pivot 130 at a predetermined angle, for example, greater than 5 degrees and less than 175 degrees, and preferably between 30 degrees and 120 degrees. Therefore, the second protective shell 120 may be transformed into a supporting stand for the electronic device 900 to support the electronic device 900 on a plane surface so as to form a display mode. Accordingly, the user may conveniently watch the pictures on the display of the electronic device 900.

In some embodiments, the electronic device protective cover 100 further includes a plurality of fixing devices 400, i.e. a first fixator 401, a second fixator 402, a third fixator 403 and a fourth fixator 404 such as bolts, rivets, magnetic buckles or any fixing device. The first fixator 401, the second fixator 402, the third fixator 403 and the fourth fixator 404 of the fixing devices 400 respectively penetrate through the first protective corner 112, the second protective corner 114, the third protective corner 122 and the fourth protective corner 124 to fix the first protective corner 112 on the first corner 901 of the electronic device 900, the second protective corner 114 on the second corner 902 of the electronic device 900, the third protective corner 122 on the third corner 903 of the electronic device 900, and the fourth protective corner 124 on the fourth corner 904 of the electronic device 900.

In some embodiments, when some of the fixing devices 400, for example, the third fixator 403 and the fourth fixator 404 such as quick release screws or magnetic fixing devices are released, the third protective corner 122 may be separated from the third corner 903 of the electronic device 900 and the fourth protective corner 124 may be separated from the fourth corner 904 of the electronic device 900 to allow the second protective shell 120 to rotate along the pivot 130 so as to allow the electronic device 900 to stand on a plane surface such as a desktop and so on.

Further referring to Fig. 2, the rotatable hand strap module 200 includes a rotating plate 220, a fixed shaft 210 and a hand strap 230. The rotating plate 220 may be rotatably installed on the second protective shell 120, and the hand strap 230 may penetrate through rotating plate 220. The fixed shaft 210 penetrates through the rotating plate 220 and the second protective shell 120 to allow the rotatable hand strap module 200 rotatably installed on the second protective shell 120.

In some embodiments, the fixed shaft 210 includes an external thread bolt 214 and an internal thread sleeve nut 212. The internal thread sleeve nut 212 penetrates through the rotating plate 220 and the second protective shell 120, and the external thread bolt 214 is fixed to the internal thread sleeve nut 212 so that the rotatable hand strap module 200 is rotatably installed on the second protective shell 120.

In some embodiments, the hand strap 230 includes a first U-shaped part 232, a second U-shaped part 234 and a third U-shaped part 236. The first U-shaped part 232, the second U-shaped part 234 and the third U-shaped part 236 are sequentially connected. In addition, the rotatable hand strap module 200 further includes a fixing ring 240, and the first U-shaped part 232 of the hand strap 230 is fixed on the fixing ring 240. Furthermore, the second U-shaped part 234 of the hand strap 230 is fixed on the rotating plate 220. The third U-shaped part 236 of the hand strap 230 may pass through the fixing ring 240 to adjust the tightness of the hand strap 230.

In some embodiments, the rotatable hand strap module 200 further includes a bonding device 250 fixed on the third U-shaped part 236 of the hand strap 230 to adjust the tightness of the hand strap 230 according to the requirement. In addition, the bonding device 250 may be a hook and loop fastener, a belt buckle, button or magnetic buckle.

Further referring to Fig. 3, as shown in the drawing, the electronic device protective cover 100 may be equipped with a rotatable hand strap module 300, and the rotatable hand strap module 300 is fixed on the second protective shell 120 through the fixed shaft 310.

The fixed shaft 310 includes an external thread bolt 314 and an internal thread sleeve nut 312. The internal thread sleeve nut 312 penetrates through the rotating plate 320 and the second protective shell 120. The external thread bolt 314 is fixed to the internal thread sleeve nut 312 so that the rotatable hand strap module 300 is rotatably installed on the second protective shell 120.

In some embodiments, the rotating plate 320 of the rotatable hand strap module 300 is connected to the hand strap 330, and the rotating plate 320 and the hand strap 330 are formed in one piece using double injection molding.

In some embodiments, the rotatable hand strap module 300 may further include a fixing ring 340, the fixing ring 340 is connected to the rotating plate 320. The fixing ring 340, rotating plate 320 and the hand strap 330 are formed in one piece using double injection molding so as to conveniently manufacture the rotatable hand strap module 300. In addition, the rotatable hand strap module 300 is formed in one piece using double injection molding so as to prevent the rotatable hand strap module 300 from being affected by moisture, and facilitate the user to use the electronic device 900 in various environments.

In the same manner, the rotatable hand strap module 300 may further include a bonding device 350 formed on the hand strap 330 to conveniently adjust the tightness of the hand strap 330 according to the requirement of the user. In some embodiments, the bonding device 350 may be a hook and loop fastener, a belt buckle, button or magnetic buckle.

Accordingly, the electronic device protective cover disclosed in the present invention may effectively protect the electronic device stored therein, and is convenient to carry and convenient for users to watch videos so as to be conveniently used in various environments and effectively improve the safety and convenience while using the electronic devices.

## Claims

1. An electronic device protective cover (100), **characterized by** comprising:
a first protective shell (110);
a second protective shell (120);
a pivot (130) connected between the first protective shell (110) and the second protective shell (120); and
a rotatable hand strap module (200, 300) rotatably installed on the second protective shell (120).

2. The electronic device protective cover (100) of claim 1, wherein the first protective shell (110) comprises:
a first protective corner (112);
a second protective corner (114); and
a connecting part (116) connected between the first protective corner (112) and the second protective corner (114).

3. The electronic device protective cover (100) of claim 2, wherein the second protective shell (120) comprises:
a base plate (126);
a third protective corner (122) disposed on the base plate (126); and
a fourth protective corner (124) disposed on the base plate (126), wherein the first protective corner (112) and the second protective corner (114) are symmetrical to the third protective corner (122) and the fourth protective corner (124).

4. The electronic device protective cover (100) of any one of claims 1 to 3, wherein the second protective shell (120) is rotatable by a predetermined angle along the pivot (130).

5. The electronic device protective cover (100) of claim 1, wherein the rotatable hand strap module (200, 300) comprises:
a rotating plate (220, 320) rotatably installed on the second protective shell (120); and
a hand strap (230, 330) penetrating through the rotating plate (220, 320).

6. The electronic device protective cover (100) of claim 5, wherein the rotatable hand strap module (200, 300) further comprises:
a fixed shaft (210, 310) penetrating through the rotating plate (220, 320) and the second protective shell (120) to allow the rotatable hand strap module (200, 300) to rotatably install on the second protective shell (120).

7. The electronic device protective cover (100) of claim 6, wherein the fixed shaft (210, 310) comprises:
an internal thread sleeve nut (212, 312) penetrating through the rotating plate (220, 320) and the second protective shell (120); and
an external thread bolt (214, 314) fixed to the internal thread sleeve nut (212, 312) so that the rotatable hand strap module (200, 300) is rotatably installed on the second protective shell (120).

8. The electronic device protective cover (100) of claim 5, wherein the hand strap (230) comprises a first U-shaped part (232), a second U-shaped part (234) connected to the first U-shaped part (232) and a third U-shaped part (236) connected to the second U-shaped part (234), wherein the second U-shaped part (234) of the hand strap (230) is fixed on the rotating plate (220).

9. The electronic device protective cover (100) of claim 8, wherein the rotatable hand strap module (200) further comprises:
a fixing ring (240), wherein the first U-shaped part (232) of the hand strap (230) is fixed on the fixing ring (240), and the third U-shaped part (236) of the hand strap (230) passes through the fixing ring (240) to adjust a tightness of the hand strap (230).

10. The electronic device protective cover (100) of claim 5, wherein the rotating plate (320) of the rotatable hand strap module (300) is connected to the hand strap (330), and the rotating plate (320) and the hand strap (330) are formed in one piece using double injection molding.

11. The electronic device protective cover (100) of claim 10, wherein the rotatable hand strap module (300) further comprises a fixing ring (340) connected to the rotating plate (320), and the fixing ring (340), the rotating plate (320) and the hand strap (330) are formed in one piece using the double injection molding.

12. The electronic device protective cover (100) of any one of the claims 8 to 11, wherein the rotatable hand strap module (200, 300) further comprises a bonding device (250, 350) formed on the hand strap (230, 330) to adjust a tightness of the hand strap (230, 330) according to a requirement.

13. The electronic device protective cover (100) as claimed in any one of the preceding claims, wherein the electronic device protective cover (100) is configured to protect an electronic device (900), **characterized by**:
wherein the first protective shell (110) and the second protective shell (120) surround the electronic device (900).

14. The electronic device protective cover (100) of claim 13, further comprising a plurality of fixing devices (400) penetrating through the first protective corner (112), the second protective corner (114), the third protective corner (122) and the fourth protective corner (124) to fix the first protective corner (112) on a first corner (901) of the electronic device (900), the second protective corner (114) on a second corner (902) of the electronic device (900), the third protective corner (122) on a third corner (903) of the electronic device (900), and the fourth protective corner (124) on a fourth corner (904) of the electronic device (900).

15. The electronic device protective cover (100) of claim 14, wherein the second protective shell (120) is configured to rotate along the pivot (130) to allow the electronic device (900) to stand on a surface when some of the fixing devices (400) are released to separate the third protective corner (122) from the third corner (903) of the electronic device (900) and the fourth protective corner (124) from the fourth corner (904) of the electronic device (900).
